# EUROPEAN PATENT APPLICATION

(11) **EP 4 328 965 A1**
(43) Date of publication of application: **28.02.2024**
(21) Application number: 23397504.4
(22) Date of filing: 23.08.2023
(51) Int. Cl.: H01L 23/427, F28D 15/02, H01L 23/367, H01L 21/48, F28F 1/06, F28F 1/34

(54) **HEAT SINK**

(30) Priority: 23.08.2022 FI 20225743
(71) Applicant: Thermal Channel Technologies Oy, 90620 Oulu (FI)
(72) Inventor: PENTIKÄINEN, Vesa, 90620 Oulu (FI); HALONEN, Severi, 90620 Oulu (FI); PENTIKÄINEN, Martti, 90620 Oulu (FI)
(74) Representative: Laine IP Oy

(57) **Abstract**

According to an example aspect of the present invention, there is provided a heat sink (100) comprising a body (110) comprising at least one branch (111, 112) extending from the body (110), a first plurality of fins (121) extending from the at least one branch (111, 112) each through a linear junction (116) between the first plurality of fins (121) and the at least one branch (111, 112), and a heat pipe (130) integrated to the body (110) and extending along an axis (A). The linear junction (116) is non-aligned with the axis (A) of the heat pipe (130).

## Description

### FIELD

The present disclosure relates to the cooling of heat sources, such as electric or optical components.

### BACKGROUND

The cooling of electric components, such as microprocessors, LEDs, IGBT modules, etc., is conventionally based on attaching a heat transfer element to physical and thermally conducting connection to the component. A typical such heat transfer element comprises a heat sink that provides for a large heat dissipation area for dissipating heat away from the component to the ambient. Also, liquid cooled heat transfer elements are known, such as radiators.

There remains, however, the need to further develop the cooling of electric components without excessively increasing the complexity of the heat transfer system or at least to provide the public with a useful alternative.

### SUMMARY OF THE INVENTION

According to a first aspect of the present invention, there is provided a heat sink comprising a body comprising at least one branch extending from the body, a first plurality of fins extending from the at least one branch each through a linear junction between the first plurality of fins and the at least one branch, and a heat pipe integrated to the body and extending along an axis, wherein the linear junction is non-aligned with the axis of the heat pipe.

Some embodiments may include one or more features from the following itemized list:
- the heat sink comprises a second plurality of fins extending from the body
- the body is configured to extend in a first dimension
- the at least one branch is configured to extend in a second dimension
- the second dimension is angled in respect to the first dimension
- the angle between the first dimension and the second dimension is 90° +/- 30°
- the at least one branch comprises a first end connected to the body and an opposite second end
- a thickness of the first end of the at least one branch is equal than a thickness of the second end of the at least one branch in the third dimension
- the first plurality of fins and the second plurality of fins extend in a third dimension
- the third dimension is angled in respect to the first and second dimension
- the first plurality of fins and the second plurality of fins extend in an angle of 90° +/-30° or +/- 20° in respect to the first and second dimension
- a diameter of the heat pipe is equal to or greater than, such as 10 % or more greater than, the greatest thickness of the at least one branch in the third dimension
- the first plurality of fins extends in two opposite directions from the at least one branch and/or the second plurality of fins extends in two opposite directions from the body in the third dimension
- a width of the first plurality of fins is greater in the second dimension than a width of the second plurality of fins
- the body comprises two branches extending in opposite directions from the body in the second dimension
- two branches extend co-planarly
- the at least one branch comprises a first portion and a second portion
- the first portion and the second portion are separated by a groove, which extends in the first dimension
- the groove comprises at least one slot or protrusion extending in the first dimension creating a threshold in the second direction
- the first plurality of fins is in an inclined angle in respect to the second plurality of fins in a Z-Y plane
- the said inclined angle is 0.1-20 degrees, preferably 15 degrees
- the first plurality of fins and the second plurality of fins extend in a direction that forms an inclined angle in respect to the axis A of the heat pipe
- the said inclined angle is 65-85 degrees, such as between 70 and 80 degrees
- the at least one branch comprises a first end connected to the body and an opposite second end
- a thickness of the first end is greater than the thickness of the second end in the third dimension

According to a second aspect of the present invention, there is provided a preform for a heat sink, comprising a body extending in a first dimension, at least one branch extending in a second dimension, which is angled in respect to the first dimension, and a heat pipe integrated to the body and having a diameter in a third dimension, which is angled in respect to the first and second dimension, wherein the diameter of the heat pipe is equal or greater than a diameter of the at least one branch in the third dimension.

According to a third aspect of the present invention, there is provided a heat transfer system comprising at least one heat sink, an adapter at an end of the body for attaching the heat sink to a base, and a base attached to the adapter, which base comprises an evaporator, which evaporator is in fluid connection with the heat pipe.

According to a fourth aspect of the present invention, there is provided a method for producing a heat sink, comprising: providing a preform, skiving a first plurality of fins extending from the at least one branch each through a linear junction between the first plurality of fins and the at least one branch, and providing a heat pipe inside the body and extending along an axis.

### BRIEF DESCRIPTION OF THE DRAWINGS

FIGURE 1 illustrates a perspective view of a heat sink in accordance with at least some embodiments of the present invention;
FIGURE 2 illustrates a top view of a heat sink of FIGURE 1 in accordance with at least some embodiments of the present invention;
FIGURE 3 illustrates an end of a heat sink comprising an adapter in accordance with at least some embodiments of the present invention;
FIGURE 4 illustrates a perspective view of a heat transfer system in accordance with at least some embodiments of the present invention;
FIGURE 5 illustrates a perspective view of a heat transfer system comprising two heat sinks in accordance with at least some embodiments of the present invention;
FIGURE 6 illustrates a perspective view of a heat sink comprising two grooves in accordance with at least some embodiments of the present invention;
FIGURE 7 illustrates a perspective view of a heat sink of FIGURE 6 comprising two grooves and an adapter in accordance with at least some embodiments of the present invention;
FIGURE 8 illustrates a top view of a heat sink of FIGURES 6 and 7 comprising two grooves and four protrusions in accordance with at least some embodiments of the present invention;
FIGURE 9 illustrates a perspective view a heat sink comprising a first plurality of fins in an inclined angle in respect to a second plurality of fins in accordance with at least some embodiments of the present invention;
FIGURE 10 illustrates a perspective view a heat sink of FIGURE 9 comprising a first plurality of fins in an inclined angle in respect to a second plurality of fins and an adapter in accordance with at least some embodiments of the present invention;
FIGURE 11 illustrates a top view of a heat sink of FIGURES 9 and 10 comprising a first plurality of fins in an inclined angle in respect to a second plurality of fins in accordance with at least some embodiments of the present invention;
FIGURE 12 illustrates a perspective view of a heat transfer system comprising two heat sinks in accordance with at least some embodiments of the present invention;
FIGURE 13 illustrates a perspective view of a heat sink comprising a first plurality of fins and a second plurality of fins extending in a direction that forms an inclined angle in respect to the axis of the heat pipe in accordance with at least some embodiments of the present invention;
FIGURE 14 illustrates a side view of a heat sink of FIGURE 13 comprising a first plurality of fins and a second plurality of fins extending in a direction that forms an inclined angle in respect to the axis of the heat pipe in accordance with at least some embodiments of the present invention;
FIGURE 15 illustrates a perspective view of a heat sink comprising a first plurality of fins and a second plurality of fins extending in a direction that forms an inclined angle in respect to the axis of the heat pipe, wherein the first plurality of fins is in an inclined angle in respect to the second plurality of fins in the third dimension in accordance with at least some embodiments of the present invention;
FIGURE 16 illustrates a side view of a heat sink of FIGURE 15 comprising a first plurality of fins and a second plurality of fins extending in a direction that forms an inclined angle in respect to the axis of the heat pipe, wherein the first plurality of fins is in an inclined angle in respect to the second plurality of fins in the third dimension in accordance with at least some embodiments of the present invention;
FIGURE 17 illustrates a side view of a heat sink of FIGURE 15 comprising a first plurality of fins and a second plurality of fins extending parallel in respect to a base, and the heat pipe extending in an inclined angle in respect to the base in accordance with at least some embodiments of the present invention;
FIGURE 18 illustrates a cross sectional view of a heat sink heat comprising a base, which comprises an evaporator and condenser in accordance with at least some embodiments of the present invention;
FIGURE 19 illustrates a preform in accordance with at least some embodiments of the present invention;
FIGURE 20 illustrates skiving of a first plurality of fins and a second plurality of fins in accordance with at least some embodiments of the present invention;
FIGURE 21 illustrates skiving of a first plurality of fins and a second plurality of fins in accordance with at least some embodiments of the present invention; and
FIGURE 22 illustrates skiving of a first plurality of fins and a second plurality of fins, wherein skiving is performed along a first dimension in accordance with at least some embodiments of the present invention.

### EMBODIMENTS

In the present context "branch" refers to an element, which extends from a body of a heat sink. A height of the branch is preferably equal than a height of the body in the greatest dimension of the body.

In the present context "fin" refers to a plate-like planar or curved element, which extends from a body or a branch of a heat sink.

In the present context "integrated" refers to an element or feature that is an integral part of another element or feature such that said elements or features are inseparable. Further, the term refers to an element or feature that is formed from a material of a body.

In the present context "heat pipe" refers to a heat-transfer device that employs phase transition to transfer heat between two solid interfaces. A heat pipe can be a thermosiphon, which is a heat pipe where a liquid is returned to the evaporator by gravitational or other accelerational forces. The thermosiphon can be a condenser of a thermosiphon.

In the present context "linear junction" refers to a join or a seam between a branch and a first plurality of fins. The linear junction can be a substantially linear line. The linear junction is formed between the branch and the first plurality of fins during skiving the first plurality of fins.

According to an embodiment, a heat sink 100 comprises a body 110 comprising at least one branch 111, 112 extending from the body, a first plurality of fins 121 extending from the at least one branch 111, 112 each through a linear junction 116 between the first plurality of fins 121 and the at least one branch 111, 112, and a heat pipe 130 integrated to the body 110 and extending along an axis A. The linear junction 116 is non-aligned with the axis A of the heat pipe 130.

The heat sink provides an effective apparatus for cooling of electric or optical components that is suitable for mass production. The sufficiently large diameter of the heat pipe enables efficient and sufficient heat transfer from the heat pipe to the at least one branch. The first plurality of fins provides a large heat dissipation area for dissipating heat away from the electric component to the ambient.

The heat sink 100 is preferably made from a thermally conducting material, such as aluminium or an aluminium alloy. The heat sink 100 may be produced by extrusion, which provides the basic shape of the heat sink 100 and may be adapted to produce heat sinks of different sizes to serve and cool variable power levels and one or more heat sources.

The heat pipe 130 is an integral part of the body 110. This means that the heat pipe 130 cannot be separated from the body 110. In the illustrated example the heat pipe 130 is formed as a cavity (Ger. *Ausnehmung*) in the basic material of the heat sink 100. The integration of the heat pipe 130 to the body 110 is achieved by boring out the channel into the body 110 after extrusion of the heat sink 100. Alternatively, the heat pipe could be produced during extrusion or casting by arranging the heat pipe to extend in the third dimension Z (not illustrated).

A height of the heat pipe 130 in the first dimension X can be greater than a diameter of the heat pipe 130 in the second dimension Y. So, the heat pipe 130 can have a tall shape. The purpose of the tall shape is to transfer heat across the first dimension X for a considerable distance to enable a sufficient opportunity for the first plurality of fins 121 and the second plurality of fins 122 to dissipate the heat.

The cross-section of the heat pipe 130 may be circular or any suitable shape.

The heat pipe 130 can have an enclosed volume, in which a heat transferring fluid is arranged to act. The heat transferring fluid is preferably a saturated vapour with little or no impurities.

The heat pipe 130 can be a blind cavity. However, also through cavities are possible, which would require a closing mechanism (not illustrated) for closing the end of the heat pipe 130.

According to an embodiment, the heat sink 100 further comprises a second plurality of fins 122 extending from the body 110. The second plurality of fins provides a large heat dissipation area for dissipating heat away from the electric component to the ambient.

The first plurality of fins 121 can comprise a stem at a proximal end in respect to the at least one branch 111, 112 and a tip at a distal end in respect to the at least one branch 111, 112. Respectively, the second plurality of fins 122 can comprise a stem at a proximal end in respect to the body 110 and a tip at a distal end in respect to the body 110. The cross-section of the tip can be equal than that of the stem in the first dimension X.

Alternatively, the cross-section of the tip can be smaller than that of the stem in the first dimension X.

According to an embodiment, the body 110 is configured to extend in a first dimension X and the at least one branch 111, 112 is configured to extend in a second dimension Y, which second dimension Y is angled in respect to the first dimension X.

According to an embodiment, the angle between the first dimension X and the second dimension Y is 90° +/- 30°. For example, the angle is 100°, 95°, 90°, 85° or 80°.

According to an embodiment, the first plurality of fins 121 and the second plurality of fins 122 extend in a third dimension Z, which is angled in respect to the first and second dimension X, Y.

According to an embodiment, the first plurality of fins 121 and the second plurality of fins 122 extend in an angle of 90° +/- 30° or +/- 20° in respect to the first dimension X and second dimension Y. For example, the first plurality of fins 121 and the second plurality of fins 122 may extend in the angle of 100°, 95°, 90°, 85° or 80° in respect to the first dimension X and the second dimension Y. When the angle is 90°, heat can be transferred directly to a side or sides of the at least one branch. By adjusting the angle, the airflow can be directed in the desired direction.

According to an embodiment, a diameter of the heat pipe 130 is equal to or greater than, such as 10 % or more greater than, the greatest thickness of the at least one branch 111, 112 in the third dimension Z. This enables producing of a heat pipe, which has a diameter large enough for efficient and sufficient heat transfer, but at the same time, the thickness of the branch can be kept small to achieve the lightness of the structure.

According to an embodiment, the at least one branch 111, 112 comprises a first end connected to the body 110 and an opposite second end, wherein a thickness of the first end is equal than thickness of the second end in the third dimension Z. In the other words, the thickness of the at least one branch can be substantially uniform from the first end to the second end in the third dimension Z. Thus, producing of the at least one branch and the first plurality of fins extending from the at least one branch is simple.

Alternatively, the thickness of the first end can be greater than the thickness of the second end.

According to an embodiment, the first plurality of fins 121 extends in two opposite directions from the at least one branch 111, 112 and/or the second plurality of fins 122 extends in two opposite directions from the body 110 in the third dimension Z. This provides a large heat dissipation area and thus efficient heat transfer, because heat can be transferred away in two directions.

According to an embodiment, a width of the first plurality of fins 121 is greater in the second dimension Y than a width of the second plurality of fins 122. So, a length of the at least one branch 111, 112 can be greater than a length of the body in the second dimension Y. This enables producing of wider fins to the at least one branch than the body. The at least one branch provides a large heat dissipation area and thus efficient heat transfer.

According to an embodiment, the body 110 comprises two branches 111, 112 extending in opposite directions from the body 110 in the second dimension Y. Both two branches 111, 112 can comprise the first plurality of fins 121 extending in a third dimension Z. The first plurality of fins 121 can extend in two opposite directions from one of the branches 111 or both of the branches 111, 112 in the third dimension Z. This provides a large heat dissipation area and thus efficient heat transfer, because heat can be transferred in two opposite directions from the body.

According to an embodiment, the two branches 111, 112 extend co-planarly. In other words, the two branches 111, 112 extend in a same geometric plane. This enables forming the first plurality of fins and the second plurality of fins by skiving and the formation of a straight and intact airflow channel.

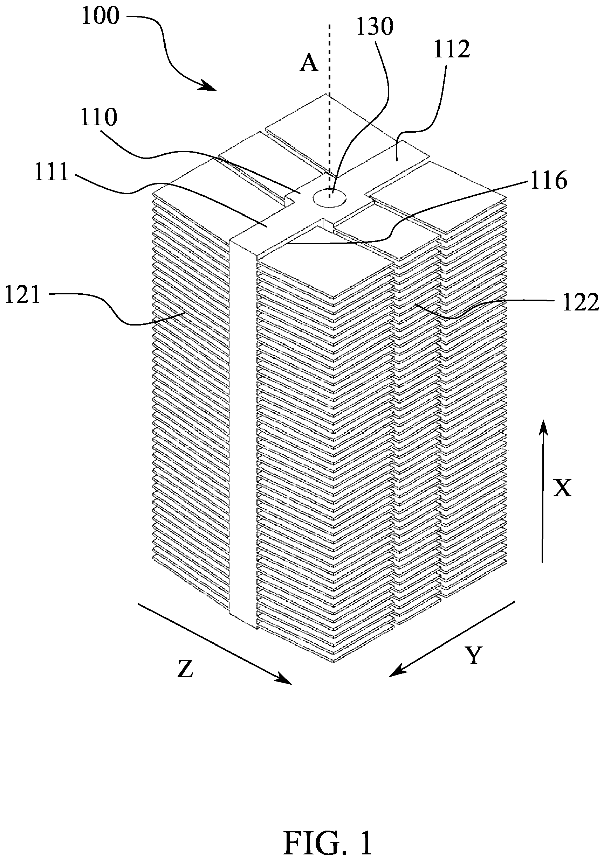

FIGURE 1 illustrates a perspective view of a heat sink 100. The heat sink 100 comprises a body 110, a heat pipe 130, two branches 111, 112, a first plurality of fins 121 and a second plurality of fins 122. The body 110 extends in a first dimension X and the two branches 111, 112 extend in a second dimension Y, which is angled in respect to the first dimension X. The first plurality of fins 121 extends from the two branches 111, 112 and the second plurality of fins 122 extends from the body 110. The first plurality of fins 121 and the second plurality of fins 122 extend in a third dimension Z, which is angled in respect to the first and second dimension Y. The heat pipe 130 integrated to the body 110.

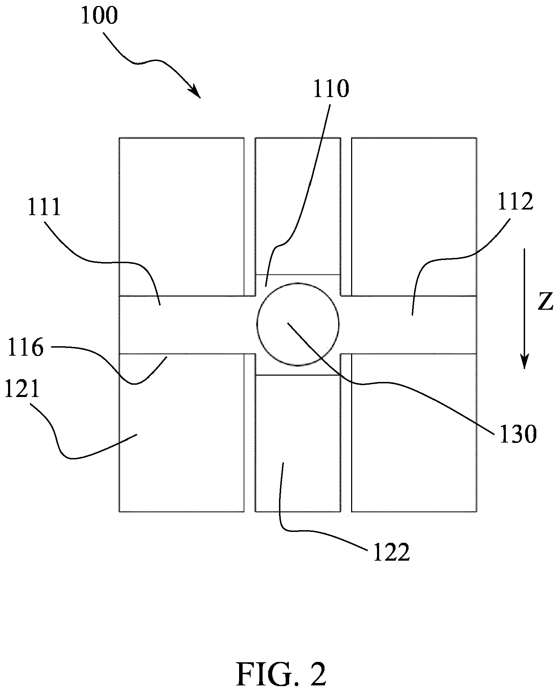

FIGURE 2 illustrates a top view of a heat sink 100 of FIGURE 1. The heat sink 100 comprises a body 110 having a heat pipe 130. Two braches 111, 112 extend in opposite directions from the body 110. There is a linear junction 116 between the first plurality of fins 121 and the two branches 111, 112. The two branches 111, 112 comprise first ends connected to the body 110 and opposite second ends. Thicknesses of the first ends are equal than the thicknesses of the second ends in the third dimension. A diameter of the heat pipe 130 is equal to thicknesses of the branches 111, 112 in the third dimension and thus a thickness of the body is larger than the thicknesses of the two branches 111, 112 in the third dimension.

The heat sink can further comprise an adapter 140 at an end of the body 110. The adapter enables the heat sink 100 to be connected to a base 150. The adapter 140 can form a male counterpart of the connection between the heat sink 100 and the base 150. Alternatively, the adapter 140 can form a female counterpart of the connection between the heat sink 100 and the base 150. The base 150 can have a recess, which forms a female counterpart. The physical connection between the adapter 140 and the base 150 may be an interference fit, particularly a shrink fit, wherein the base 150 is first heated, then the adapter 140 is installed, whereby the cooling and shrinking base 150 forms a tight connection. The physical connection between the adapter 140 and the base 150 may be a press fit or a combination of the press fit and the shrink fit. Alternatively or additionally, the connection may comprise threads (not illustrated) between the adapter 140 and the base 150. Additionally or alternatively, the connection between the adapter 140 and the base 150 may be facilitated through a keyway, wedge key, welding, adhesives, a taper joint or any known attachment method generally known in the field.

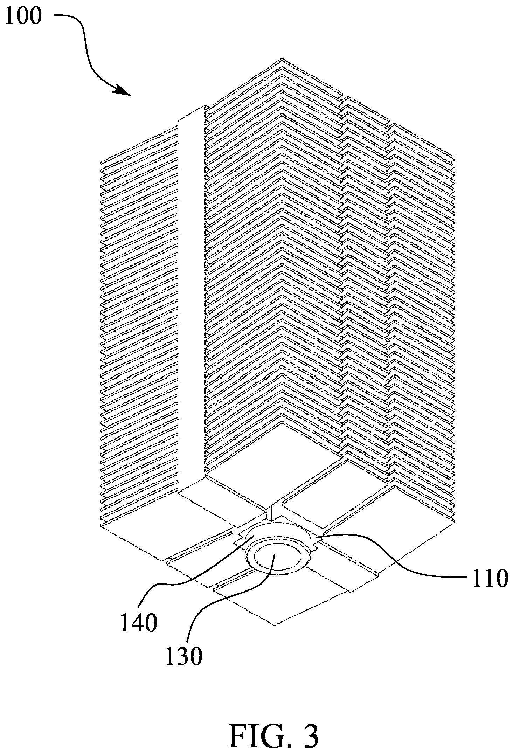

FIGURE 3 illustrates an end of a heat sink 100 comprising an adapter 140. The heat sink 100 comprises a body 110 and a heat pipe 130 integrated to the body 110. The adapter 140 is arranged concentric with the heat pipe 130. The adapter 140 extends from the body 110 in the first dimension X.

According to an embodiment, the at least one branch 111, 112 comprises a first portion 111a, 112a and a second portion 111b, 112b, which are separated by a groove 113, which extends in the first dimension X. In other words, the at least one branch 111, 112 comprises two portions, which are separated by the groove 113, which extends in the first dimension X. The groove enables of manufacturing of a lightweight heat sink strcuture, for example, for 5G (fifth generation) mobile network base station. Further, the groove enables airflow in the first dimension X.

A shape of the groove 113 can be V-shape or U-shape. A width of the groove can be greater at the farthest end from the heat pipe 130 than at the other end in the third dimension Z.

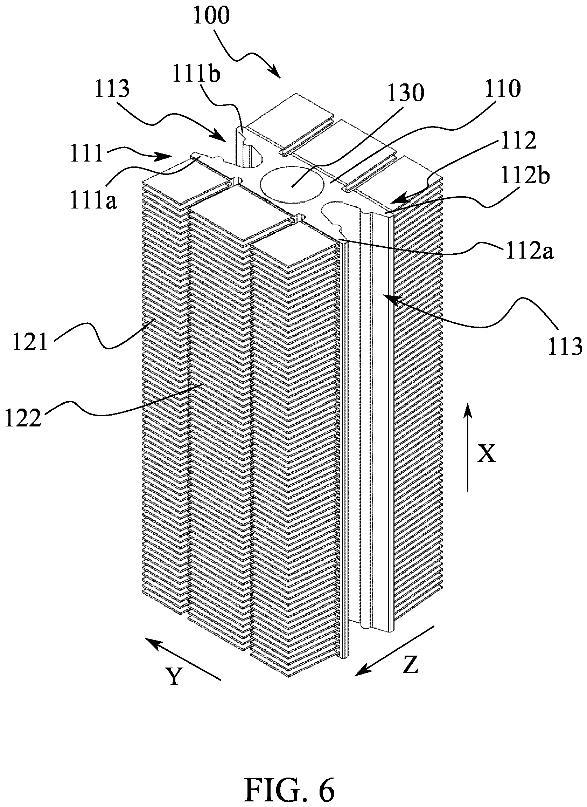

FIGURE 6 illustrates a perspective view of a heat sink 100 comprising two grooves 113. The grooves 113 extends in a first dimension X in opposite sides of the body 110. The heat sink 100 further comprises two branches 111, 112. The two branches 111, 112 comprise first portions 111a, 112a and second portions 111b, 112b, which are separated by the groove 113. A first plurality of fins 121 extend from the two branches 111, 112 and a second plurality of fins 122 extend from the body 110. A heat pipe 130 integrated to the body.

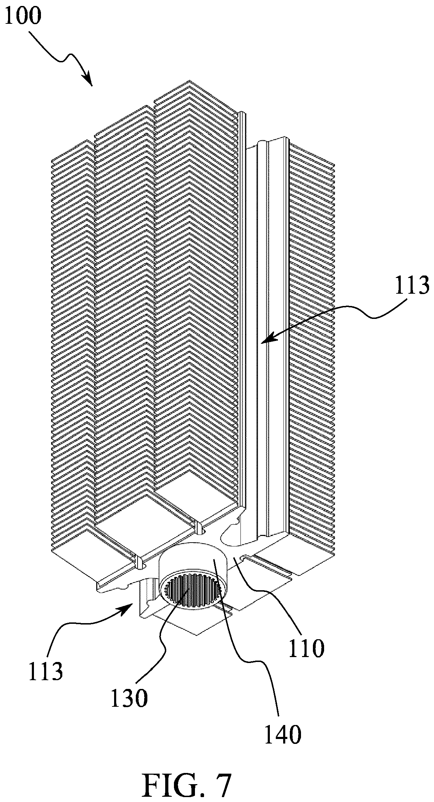

FIGURE 7 illustrates a perspective view of a heat sink 100 of FIGURE 6 comprising two grooves 113 and an adapter 140. The grooves 113 extend in a first dimension X in opposite directions from a body 110. The adapter 140 is attached at an end of the body 110. The adapter 140 is arranged concentric with the heat pipe 130. The adapter 130 extends from the body 110 in the first dimension.

According to an embodiment, the groove 113 comprises at least one slot or protrusion 115 extending in the first dimension X creating a threshold in the second dimension Y. The at least one slot or protrusion enables two heat sinks to be connected together by an intermediate part, which has at least one protrusion or slot corresponding a shape of the at least one slot or protrusion of the groove. Thus, larger heat transfer systems can be built from the heat sinks. This in turn enables more efficient heat transfer from larger heat sources.

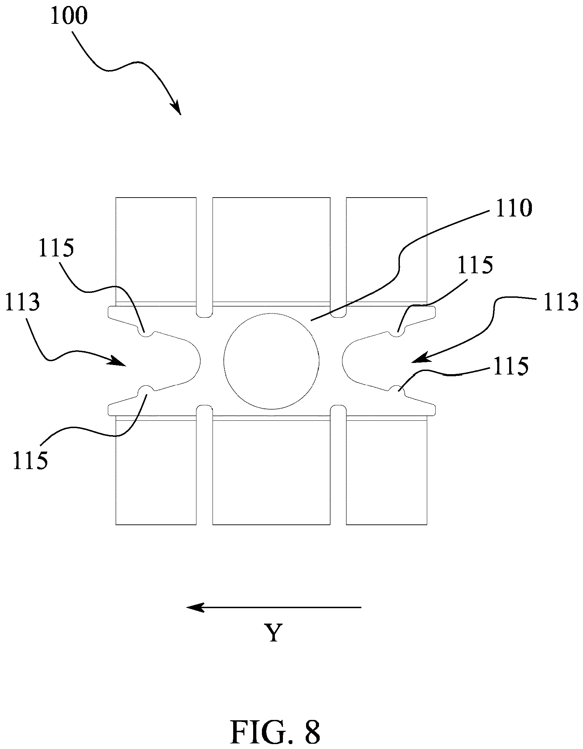

FIGURE 8 illustrates a top view of a heat sink 110 of FIGURE 6 and 7 comprising two grooves 113 and four protrusions 115. The grooves 113 extends in a first dimension X in opposite sides of the body 110. The protrusions 115 are arranged on inner surfaces of the grooves 113. The protrusions 115 are arranged in pairs so that one of the protrusions is on one side of the groove and the other of the two protrusions is on the other side of the groove.

According to an embodiment, the first plurality of fins 121 is in an inclined angle α in respect to the second plurality of fins 122 in a Z-Y plane. The inclined angle α extends around the intersection of the projections of the sides of the first plurality of fins 121 and the second plurality of fins 122. This provides an aerodynamic shape for the heat sink, which in turn provides effective heat transfer. Further, air can flow between the first plurality of fins and the second plurality of fins in the first dimension X.

According to an embodiment, the inclined angle α is 0.1-20 degrees, preferably 15 degrees.

According to an embodiment, the at least one branch 111, 112 comprises a first end connected to the body 110 and an opposite second end, wherein a thickness of the first end is greater than a thickness of the second end in the third dimension Z. This provides an aerodynamic shape for the heat sink, which in turn provides effective heat transfer.

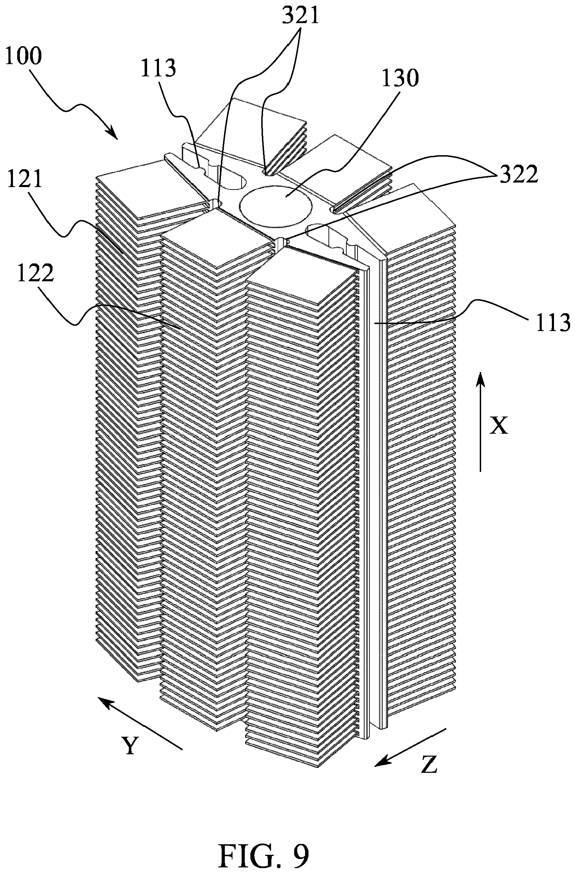

FIGURE 9 illustrates a perspective view of a heat sink 100 comprising a first plurality of fins 121 in an inclined angle in respect to a second plurality of fins 122. The first plurality of fins is bended according to grooves 321, 322 between the first plurality of fins and the second plurality of fins. Two branches 111, 112 comprise first ends connected to the body 110 and opposite second ends. A thickness of the first end is greater than a thickness of the second end in the third dimension Z. The heat sink 100 further comprises two grooves 113 extending in a first dimension X in opposite sides of the body. A heat pipe 130 is integrated to the body and extends in the first dimension X. The heat sink 100 according to FIGURE 9 has an aerodynamic shape, which provides effective heat transfer.

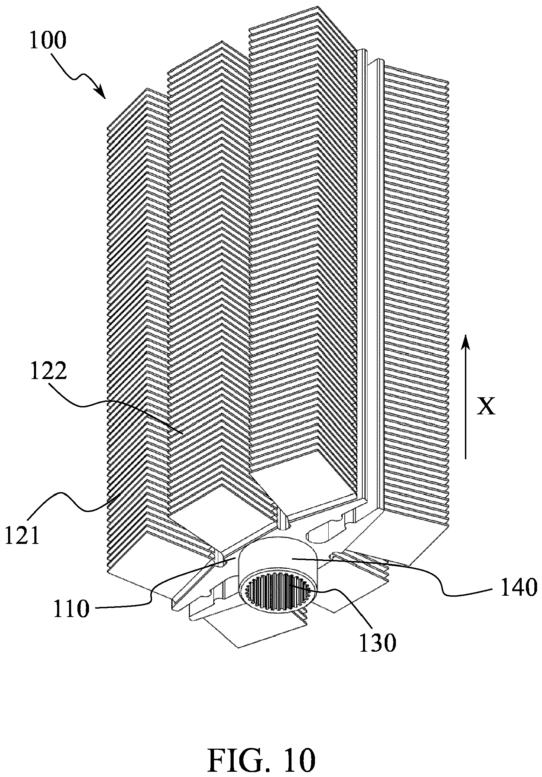

FIGURE 10 illustrates a perspective view of a heat sink 100 of FIGURE 9 comprising a first plurality of fins 121 in an inclined angle in respect to a second plurality of fins 122 and an adapter 140. The adapter 140 is attached at an end of a body 110. The adapter 140 is arranged concentric with the heat pipe 130. The adapter 140 extends from the body 110 in the first dimension X.

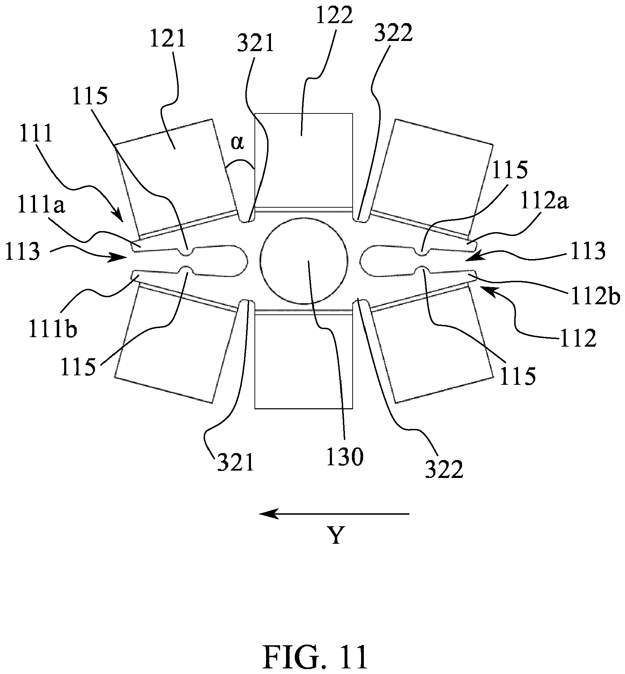

FIGURE 11 illustrates a top view of a heat sink 100 of FIGURES 9 and 10 comprising a first plurality of fins 121 in an inclined angle α in respect to a second plurality of fins 122. The first plurality of fins is bended according to grooves 321, 322 between the first plurality of fins and the second plurality of fins. The heat sink 100 comprises two branches 111, 112. The two branches 111, 112 comprise first portions 111a, 112a and second portions 111b, 112b, which are separated by grooves 113. A heat pipe 130 integrated to the body. Protrusions 115 are arranged on inner surfaces of the grooves 113 extending in the first dimension X. The protrusions 115 are arranged in pairs so that one of the protrusions is on one side of the groove and the other of the two protrusions is on the other side of the groove.

According to an embodiment, the first plurality of fins 121 and the second plurality of fins 122 extend in a direction that forms an inclined angle β in respect to the axis A of the heat pipe 130.

According to an embodiment, the inclined angle β is 65-85 degrees, such as between 70 and 80 degrees.

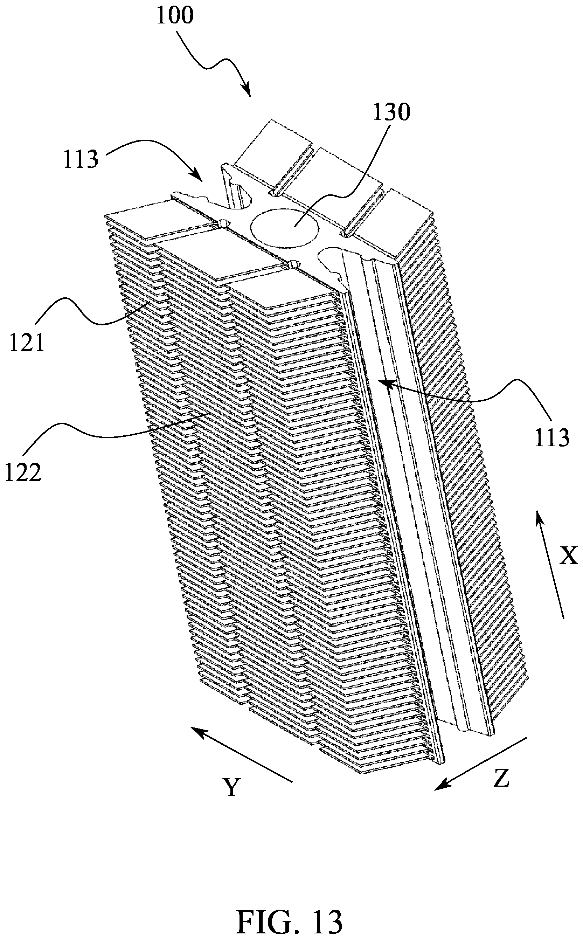

FIGURE 13 illustrates a perspective view of a heat sink 100 comprising a first plurality of fins 121 and a second plurality of fins 122 extending in a direction that forms an inclined angle β in respect to the axis A of the heat pipe 130. The heat sink 100 comprises two branches, which comprise a first portion and a second portion, which are separated by a groove 113, which extends in the first dimension X.

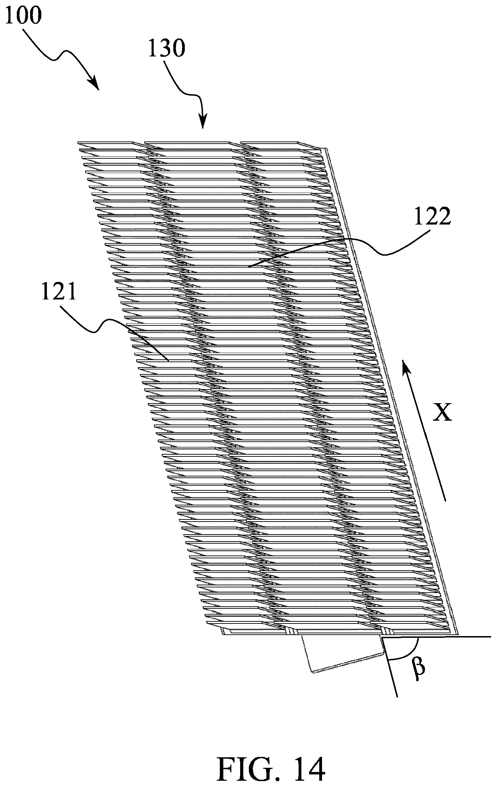

FIGURE 14 illustrates a side view of a heat sink 100 of FIGURE 13 comprising a first plurality of fins 121 and a second plurality of fins 122 extending in a direction that forms an inclined angle β in respect to the axis A of the heat pipe 130.

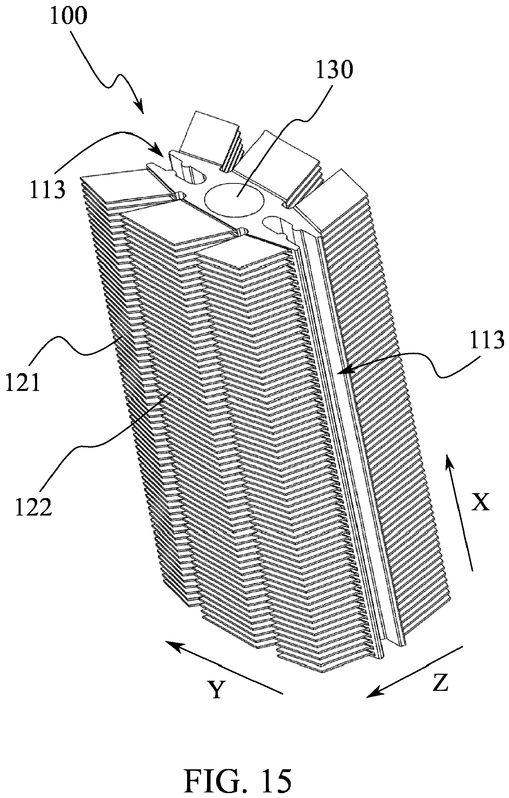

FIGURE 15 illustrates a perspective view of a heat sink 100 comprising a first plurality of fins 121 and a second plurality of fins 122 extending in a direction that forms an inclined angle β in respect to the axis A of the heat pipe 130. The heat sink 100 comprises two branches 111, 112, which comprise first portions and second portions, which are separated by grooves 113, which extends in the first dimension X. The first plurality of fins 121 is in an inclined angle in respect to the second plurality of fins 122 in the third dimension Z.

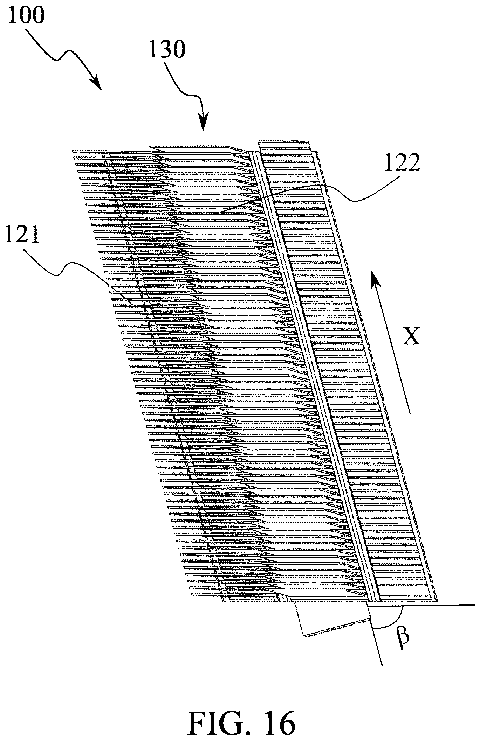

FIGURE 16 illustrates a side view of a heat sink 100 of FIGURE 15 comprising a first plurality of fins 121 and a second plurality of fins 122 extending in a direction that forms an inclined angle β in respect to the axis A of the heat pipe 130. The first plurality of fins 121 is in an inclined angle in respect to the second plurality of fins 122 in the third dimension Z.

According to an embodiment, a heat transfer system 200 comprises at least one heat sink 100 as described above, an adapter 140 at an end of the body 110 for attaching the heat sink 100 to a base 150, and a base 150 attached to the adapter 140, which base 150 comprises an evaporator 151. The evaporator 151 is in fluid connection with the heat pipe 130.

Evaporator 151 has a width in the second dimension Y and a height in the first dimension X. The width is, at least according to some embodiments, considerably larger than the height making the evaporator generally flat. The purpose of the flat shape is to collect heat from a wider area to the heat pipe and distribute the heat across the second dimension Y. Such an effect is particularly useful in spreading and distributing heat from a hot spot or a small area heat source to a wide surface area or to a large volume. The evaporator has an enclosed volume, in which a heat transferring fluid is arranged to act. The heat transferring fluid is preferably a saturated vapour with little or no impurities. The evaporator may include a support structure, such as a rigid mesh or a porous sheet, (not illustrated) to prevent the chamber from collapsing.

According to an embodiment, the first plurality of fins 121 and the second plurality of fins 122 extend parallel in respect to the base 150, and the heat pipe 130 extends in an inclined angle in respect to the base 150. This enables the heat sink to be attached at an angle, so that the fins are parallel to the base.

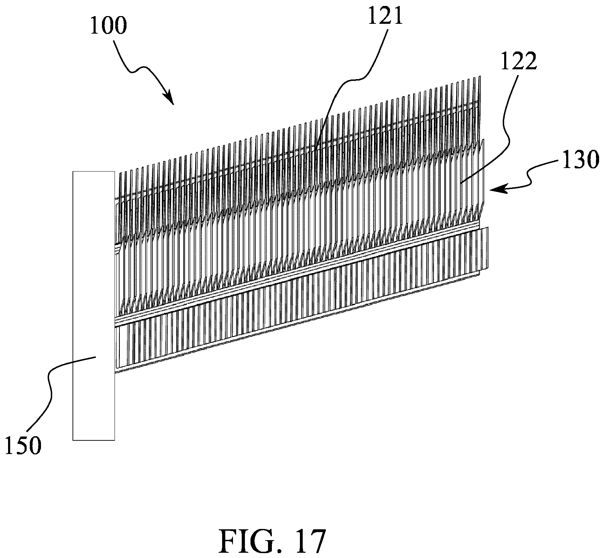

FIGURE 17 illustrates a side view of a heat sink 100 of FIGURE 15 comprising a first plurality of fins 121 and a second plurality of fins 122 extending parallel in respect to the base 150, and the heat pipe 130 extending in an inclined angle in respect to the base 150.

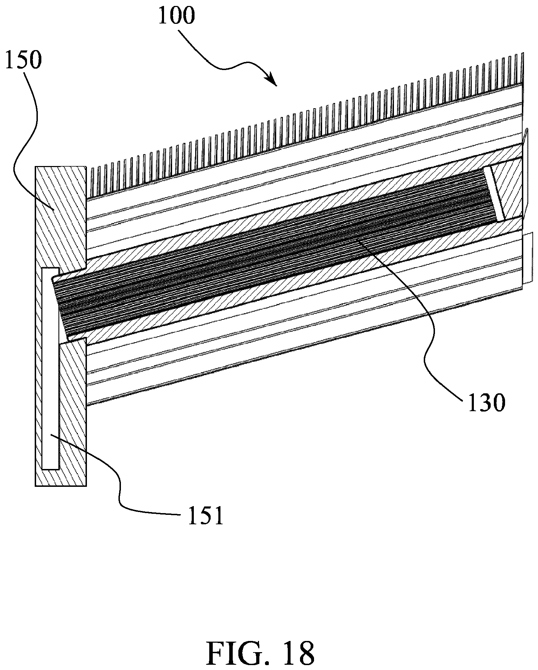

FIGURE 18 illustrates a cross sectional view of a heat sink 100 comprising a base 150, which comprises an evaporator 151 and a condenser. The first plurality of fins 121, the second plurality of fins 122 and the base 150 are in parallel planes, and the heat pipe 130 is in an inclined angle in respect to the said parallel planes.

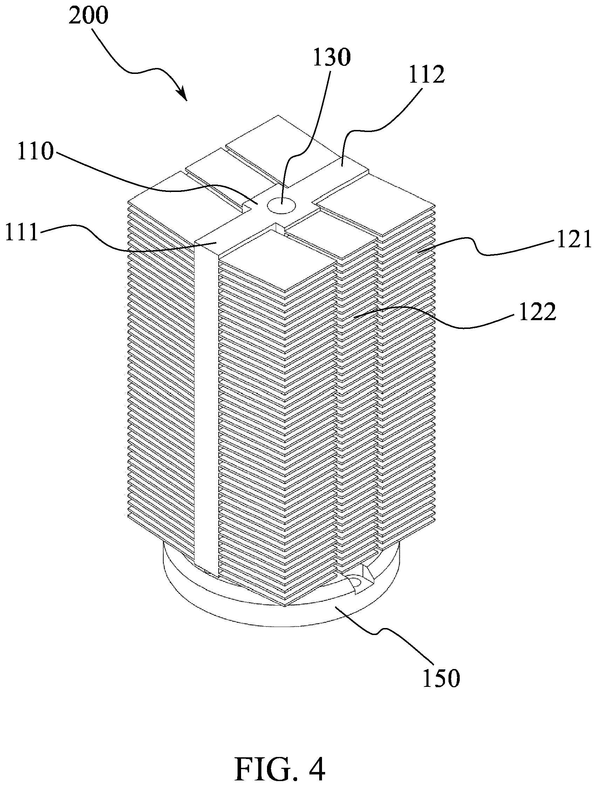

FIGURE 4 illustrates a perspective view of a heat transfer system 200. The heat transfer system comprises a heat sink 100. A base 150 is attached to an end of the heat sink 100.

According to an embodiment, the heat transfer system 200 comprises a plurality of heat sinks 100, wherein the braches 111, 112 of the heat sinks 100 are arranged in the second dimension Y. The at least two heat sinks 100 can be attached to a same base 150 via adapters 140 of the heat sinks 100. Due to two or more heat sinks, better performance is obtained compared to one larger heat sink, because there is more performance enhancing heat pipes and the distance from the heat pipe to the air interface is shorter.

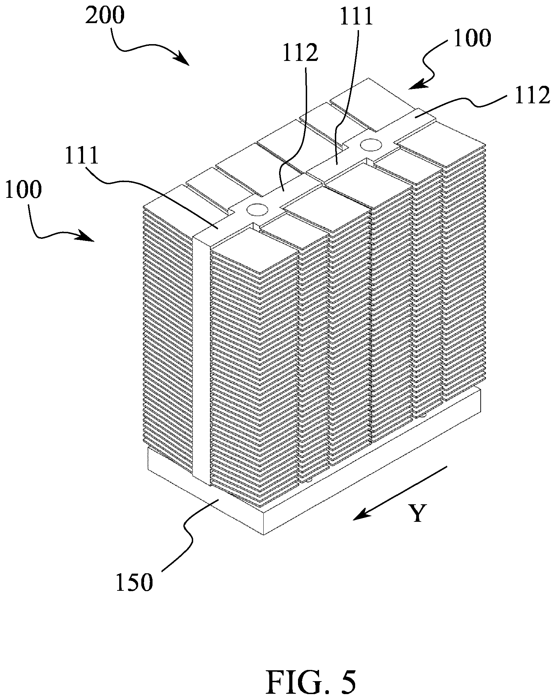

FIGURE 5 illustrates a perspective view of a heat transfer system 200 comprising two heat sinks 100. The two heat sinks are attached to a same base 150 via adapters of the heat sinks. The both of the heat sinks 100 comprise two branches 111, 112. The two braches 111, 112 are arranged in the second dimension Y.

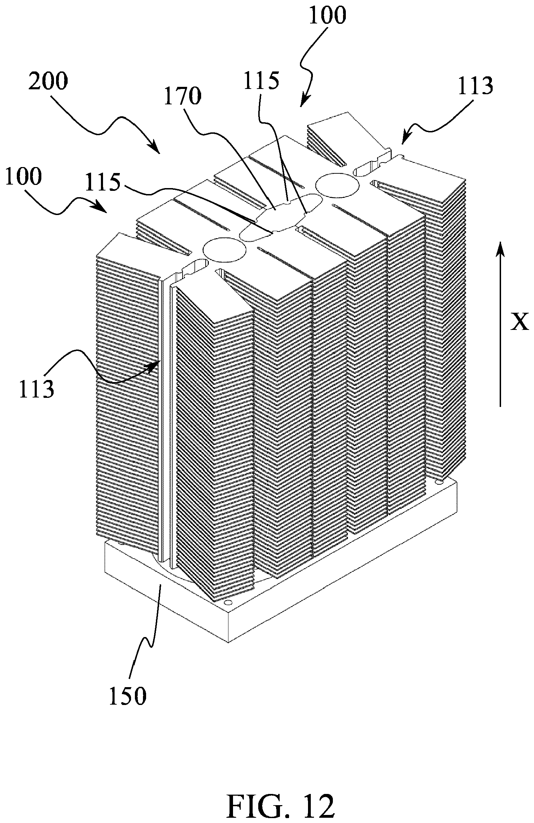

FIGURE 12 illustrates a perspective view of a heat transfer system 200 comprising two heat sinks 100. The two heat sinks 100 are attached to a same base 150 via adapters of the heat sinks. The two heat sinks 100 comprises grooves 113, which extend in the first dimension X. The grooves 113 comprises protrusions 115. The heat sinks 100 are connected together via protrusions 115 of the grooves 113 facing each other by an intermediate part 170. The outermost fins, i.e. the first plurality of fins 121, of the heat transfer system are in an inclined angle in respect to the second plurality of fins 122 in the third dimension Z.

According to an embodiment, a preform 300 for a heat sink 100 comprises a body 110 extending in a first dimension X. The preform 300 comprises at least one branch 111, 112 extending in a second dimension Y, which is angled in respect to the first dimension X. The preform 300 further comprises a heat pipe 130 integrated to the body 110 and having a diameter in a third dimension Z, which is angled in respect to the first and second dimension X, Y. The diameter of the heat pipe 130 is equal or greater than a diameter of the at least one branch 111, 112 in the third dimension Z.

According to an embodiment, the at least one branch 111, 112 of the preform 300 comprises a first portion 111a, 112a and a second portion 111b, 112b, which are separated by a groove 113, which extends in the first dimension X.

According to an embodiment, the preform 300 comprises at least two side surfaces 311, 312, 313 in a same plane. In other words, the at least two side surfaces 311, 312, 313 extend in a same geometric plane. Preferably, the preform 300 comprises three side surfaces 311, 312, 313 in a same plane.

According to an embodiment, the at least two side surfaces 311, 312, 313 are separated by at least one groove 321, 322, which extends in the first dimension X. During skiving, the grooves 321, 322 can divide the first plurality of fins and the second plurality of fins into separate sets. Further, the grooves 321, 322 facilitate bending of the fins to an inclined angle in respect to the second plurality of fins 122 in the third dimension Z.

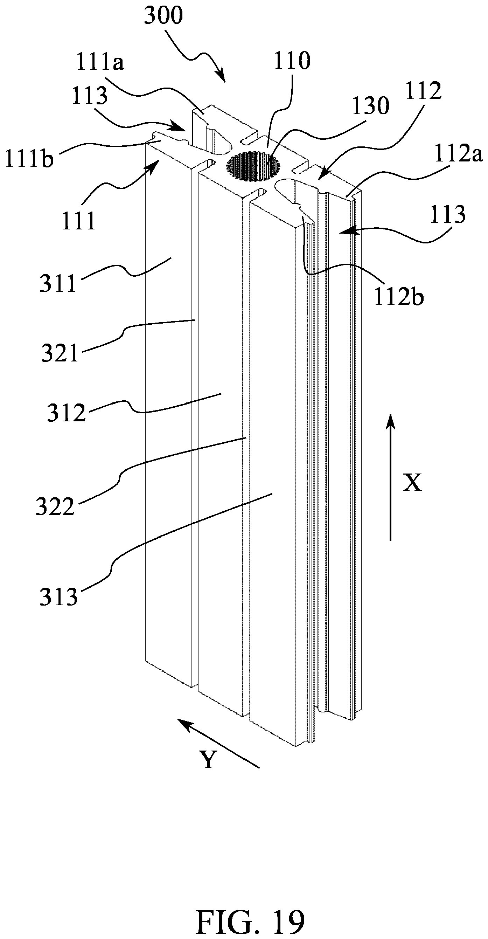

FIGURE 19 illustrates a preform 300. The preform 300 comprises two branches 111, 112 extending in a second dimension Y. The branches 111, 112 comprises first portions111a, 112a and second portions 111b, 112b, which are separated by grooves 113, which extend in the first dimension X. The preform 300 comprises a heat pipe 130, which is integrated to a body 110. The preform has three side surfaces 311, 312, 313 in a same plane, which side surfaces are connected together by grooves 321, 322 extending in the first dimension X. A shape of the preform enables skiving with a straight cutting tool.

According to an embodiment, a method for producing a heat sink 100, comprises:
- providing a preform 300 as described above,
- skiving a first plurality of fins 121 extending from the at least one branch 111, 112 each through a linear junction 116 between the first plurality of fins 121 and the at least one branch 111, 112, and
- providing a heat pipe 130 inside the body 110 and extending along an axis A.

The method enables a straightforward and effective way to produce a large quantity of dissipating fins, i.e. the first plurality of fins. Skiving enables creating the body and the fins from a single piece of material, providing improved heat dissipation and heat transfer from the body to the fins. Additionally, the skiving process also increases the roughness of the fins. The roughness increases the fins' surface area on which to dissipate heat into the air. The fins may be made much thinner and closer together than by extrusion or formed sheet processes. Thus, the method enables producing a heat sink having a simple structure and efficient heat transfer capability.

According to an embodiment, the method can further comprise skiving a second plurality of fins 122 extending from the body 110.

According to an embodiment, the body 100 is provided by extrusion, additive manufacturing, molding, injection molding or sintering.

According to an embodiment, during said skiving, a cutting tool 160 is pressed against the body 110 and the at least one branch 111, 112 in the third dimension Z and skiving is performed in an inclined angle γ in respect to axis A. The skiving can be performed in the extrusion direction of the preform. The skiving is performed in two stages. In the first stage the cutting blade is driven into a top surface of a preform profile of the body in a small angle, almost along the top surface, to drive the blade into the raw material. With the fin formed, the second stage includes retracting the cutting blade from the preform profile, elevating the blade, and driving the blade against the fin to turn the fin in an angle relative to the base. The skiving is performed to a depth, which does not remove the fin off the body or the branch but rather leaves the fin attached from the stem to the body or the branch. The cutting tool is repeatedly pressed against the body and the branch until the semi-finished heat sink includes the desired number of fins. This enables a simple way to produce a large quantity of dissipating fins.

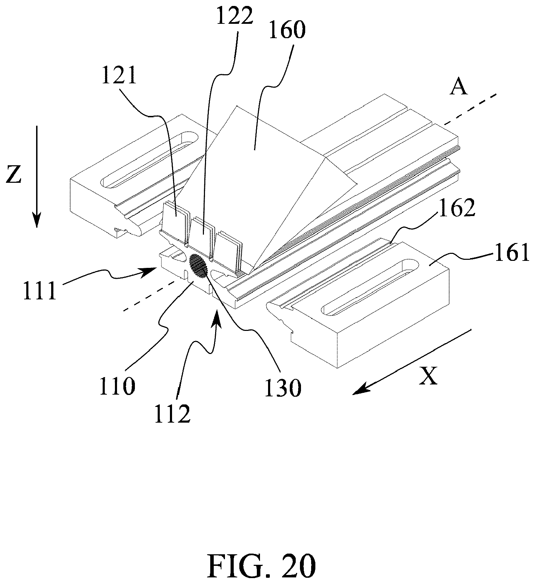

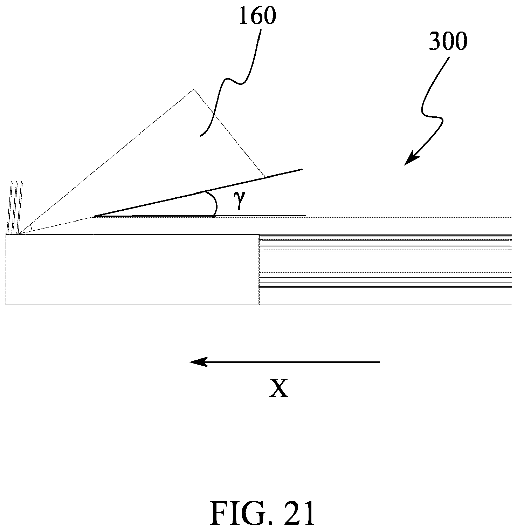

FIGURES 20 and 21 illustrate skiving of a first plurality of fins 121 and a second plurality of fins 122. A cutting tool 160 is pressed against a body 110 and branches 111, 112 in the third dimension Z and skiving is performed along the first dimension X. A shape of a preform enables the preform to be attached in a place with fastening element 161 for the skiving. The fastening element 161 can comprise a fastening groove 162 or a fastening protrusion (not illustrated), which correspond to a shape of a protrusion 115 or a slot of the preform, which protrusion or slot extend in the first dimension X. Convex or concave shapes of the fastening protrusions or the fastening grooves compensate for machining forces.

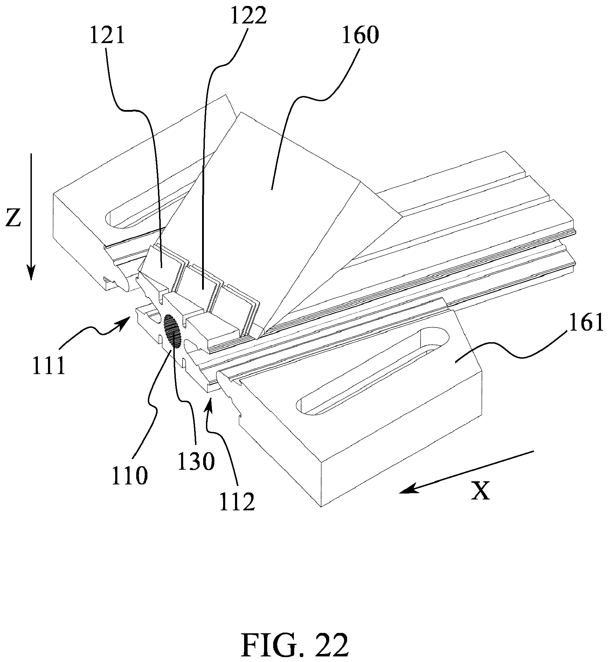

FIGURE 22 illustrates skiving of a first plurality of fins 121 and a second plurality of fins 122, which extend in a direction that forms an inclined angle β in respect to the axis A of the heat pipe 130 of a heat sink. A cutting tool 160 is pressed against a body 110 and branches 111, 112 in an inclined angle in a third dimension Z and skiving is performed along a first dimension X.

After the skiving, the tips of the first plurality of the fins 121 and the second plurality of the fins 122 can be cut to make the fins equal in a length in the third dimension Z.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", i.e. a singular form, throughout this document does not exclude a plurality.

**REFERENCE SIGNS LIST**

| | |
|---|---|
| 100 | heat sink |
| 110 | body |
| 111 | branch |
| 111a | first portion of branch |
| 111b | second portion of branch |
| 112 | branch |
| 112a | first portion of branch |
| 112b | second portion of branch |
| 113 | groove |
| 115 | protrusion |
| 116 | linear junction |
| 121 | first plurality of fins |
| 122 | second plurality of fins |
| 130 | heat pipe |
| 140 | adapter |
| 150 | base |
| 151 | evaporator |
| 160 | cutting blade |
| 161 | fastening element |
| 162 | fastening groove |
| 170 | intermediate part |
| 200 | heat transfer system |
| 300 | preform |
| 311-313 | side surface |
| 321-322 | groove |

## Claims

1. A heat sink (100) comprising:
- a body (110) comprising at least one branch (111, 112) extending from the body (110),
- a first plurality of fins (121) extending from the at least one branch (111, 112) each through a linear junction (116) between the first plurality of fins (121) and the at least one branch (111, 112), and
- a heat pipe (130) integrated to the body (110) and extending along an axis (A),
wherein in that the linear junction (116) is non-aligned with the axis (A) of the heat pipe (130).

2. The heat sink (100) of claim 1, wherein the heat sink (100) further comprises a second plurality of fins (122) extending from the body (110).

3. The heat sink (100) of claim 1 or 2, wherein the body (110) is configured to extend in a first dimension (X) and the at least one branch (111, 112) is configured to extend in a second dimension (Y), which second dimension (Y) is angled in respect to the first dimension (X), wherein the angle between the first dimension (X) and the second dimension (Y) is 90° +/- 30°.

4. The heat sink (100) according to any one of the preceding claims 2 to 3, wherein the first plurality of fins (121) and the second plurality of fins (122) extend in a third dimension (Z), which is angled in respect to the first and second dimension (X, Y), wherein the first plurality of fins (121) and the second plurality of fins (122) extend in an angle of 90° +/-30° or +/- 20° in respect to the first and second dimension (X, Y).

5. The heat sink (100) according to any one of the preceding claims, wherein the body (110) comprises two branches (111, 112) extending in opposite directions from the body (110) in the second dimension (Y).

6. The heat sink (100) according to claim 5, wherein the at least one branch (111, 112) comprises a first portion (111a, 112a) and a second portion (111b, 112b), which are separated by a groove (113), which extends in the first dimension (X).

7. The heat sink (100) according to claim 6, wherein the first plurality of fins (121) is in an inclined angle (α) in respect to the second plurality of fins (122) in a Z-Y plane, wherein the inclined angle (α) is 0.1-20 degrees, preferably 15 degrees.

8. The heat sink (100) according to any one of the preceding claims, wherein the first plurality of fins (121) and the second plurality of fins (122) extend in a direction that forms an inclined angle (β) in respect to the axis (A) of the heat pipe (130), wherein the inclined angle (β) is 65-85 degrees, such as between 70 and 80 degrees.

9. A preform (300) for a heat sink (100), comprising:
- a body (110) extending in a first dimension (X),
- at least one branch (111, 112) extending in a second dimension (Y), which is angled in respect to the first dimension (X), and
- a heat pipe (130) integrated to the body (110) and having a diameter in a third dimension (Z), which is angled in respect to the first and second dimension (X, Y),
wherein the diameter of the heat pipe (130) is equal or greater than a diameter of the at least one branch (111) in the third dimension (Z).

10. The preform (300) of claim 9, wherein the at least one branch (111, 112) comprises a first portion (111a, 112a) and a second portion (111b, 112b), which are separated by a groove (113), which extends in the first dimension (X).

11. The preform (300) of any one of the preceding claims 9 to 10, wherein the preform (300) comprises at least two side surfaces (311, 312, 313) in a same plane, and the at least two side surfaces (311, 312, 313) are separated by at least one groove (321, 322), which extends in the first dimension (X).

12. A heat transfer system (200) comprising:
- at least one heat sink (100) according to claim any one of the preceding claims 1 to 8,
- an adapter (140) at an end of the body (110) for attaching the heat sink (100) to a base (150), and
- a base (150) attached to the adapter (140), which base (150) comprises an evaporator (151), which evaporator (151) is in fluid connection with the heat pipe (130).

13. A method for producing a heat sink (100), comprising:
- providing a preform (300) according to any one of the preceding claims 9 to 11,
- skiving a first plurality of fins (121) extending from the at least one branch (111, 112) each through a linear junction (116) between the first plurality of fins (121) and the at least one branch (111, 112), and
- providing a heat pipe (130) inside the body (110) and extending along an axis (A).

14. The method according to claim 13, wherein the method further comprises skiving a second plurality of fins (122) extending from the body (110).

15. The method according to any one of the preceding claims 13 to 14, wherein during said skiving a cutting tool (160) is pressed against the body (110) and the at least one branch (111) in the third dimension (Z) and skiving is performed in an inclined angle (γ) in respect to the axis (A).
